# EUROPEAN PATENT SPECIFICATION

(11) **EP 3 747 652 B1**
(45) Date of publication and mention of the grant of the patent: **05.01.2022**
(21) Application number: 20176077.4
(22) Date of filing: 22.05.2020
(51) Int. Cl.: B32B 37/12, B32B 41/00, H01L 21/67, G02F 1/13, B29C 48/08, B05C 5/02

(54) **METHOD FOR MANUFACTURING JOINED MEMBER**
VERFAHREN ZUR HERSTELLUNG EINES VERBUNDENEN ELEMENTS
PROCÉDÉ DE FABRICATION D'UN ÉLÉMENT ASSEMBLÉ

(30) Priority: 06.06.2019 JP 2019106536
(43) Date of publication of application: 09.12.2020
(73) Proprietor: Origin Company, Limited, Saitama-shi Saitama 3380823 (JP)
(72) Inventor: Sakamoto, Masaki, Saitama, 338-0823 (JP); Inaya, Kosuke, Saitama, 338-0823 (JP); Miyazaki, Masaru, Saitama, 338-0823 (JP)
(74) Representative: Wallin, Nicholas James

(56) References cited:
- JP-A- 2001 310 149
- JP-A- 2010 051 845
- KR-A- 20160 087 574
- US-A1- 2019 118 449
- US-B2- 10 011 100

## Description

### TECHNICAL FIELD

The present invention relates to a method for manufacturing a joined member

### BACKGROUND ART

In image display devices for use in information terminals such as smartphones, tablet terminals, and in-vehicle products, a light-permeable member is joined to a surface of an image display panel via an adhesive composed of a light-permeable resin or the like for the purpose of protecting the image display panel from external impacts or of improving contrast.

In JP2010051845A, there is described a method for coating resinous coating liquid. In the method, a slot die coater which ejects the resinous coating liquid from a manifold onto a base material film via a slot is used to form the resin layer which becomes one component of an optical functional film. The slot of the slot die coater has a slot upstream region which is formed at the same height D₁ as that of a communication port with the manifold and a slot downstream region which is formed at the same height D₂ as that of a slot exit. D₁ and D₂ satisfy a following relational expression (1): 1<D₂/D₁≤5 and further D₂ and thickness T of a coating film which is coated on the base material film and is in an undried state satisfy a following relational expression (2): D₂/T≤20.

For example, in Patent Document 1 (Japanese Patent No. 6465157), it is described that a member having a light-shielding layer formed along its peripheral edges is employed as a light-permeable cover member to be joined to an image display member and a light-permeable resin is applied to this light-permeable cover member. In addition, in this Patent Document 1, there is described a resin dispenser for applying the light-permeable resin in which an dispensing port is formed to have an larger width at its longitudinal end sides than the width at its longitudinal center so that when the light-permeable resin is applied to the entire surface of the light-permeable cover member with a light-shielding layer formed thereon, the surface of the applied light-permeable resin film can be flat.

### SUMMARY OF THE INVENTION

### PROBLEM TO BE SOLVED BY THE INVENTION

What is described in the above Patent Document 1 is a technique for applying a light-permeable resin to a light-permeable cover member side and for flatly applying the light-permeable resin to the light-permeable cover member. Thus, in this Patent Document 1, the unevenness on the light-permeable cover member is taken into consideration but the state on the side of the image display member to which the light-permeable cover member is joined, in particular, the presence of unevenness on its joint surface, is not taken into consideration.

In view of the above-mentioned respects, an object of the present invention is to provide a method for manufacturing a joined member capable of successfully joining a light-permeable member to an image display panel having unevenness formed on its joint surface.

### MEANS FOR SOLVING THE PROBLEM

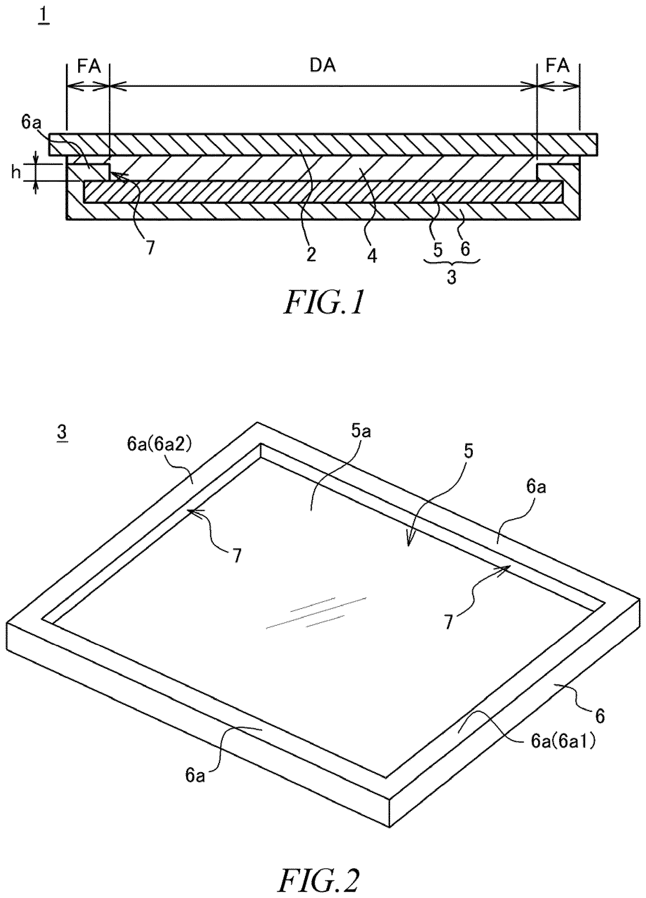

A method for manufacturing a joined member according to an aspect of the present invention includes, as shown in FIGs. 1, 4, 6 and 7, for example, including applying a light-permeable resin to a surface of an image display panel using a die head, the image display panel having a frame along an outer periphery thereof and therefore having level difference portions at a boundary between the frame and a main surface portion thereof, the method including: providing a pair of die blocks at least one of which has a supply path for the light-permeable resin formed therein and which detachably interposes a first and second shims to define a dispensing port; selecting the first shim and the second shim based on an outer shape of the image display panel and a dimension of the level difference portions, the first shim constituted of a thin plate-like member having a slit-like first dispensing port that defines part of the dispensing port and corresponds to a length of the main surface portion in a direction in which the die head extends, the second shim constituted of a thin plate-like member having a slit-like second dispensing port that defines part of the di spensing port and has a length greater than the length of the main surface portion in the direction in which the die head extends; assembling the die head by interposing the first and second selected shims between the pair of die blocks; supplying the light-permeable resin from the dispensing port while relatively moving the die head above a surface of the image display panel; and joining a light-permeable member to the surface of the image display panel with the light-permeable resin supplied thereon.

With the configuration as described above, because the first and second shims are selected and used based on dimensions of the image display panel 3, the amount of the light-permeable resin applied onto the frame and the amount of the light-permeable resin applied onto the main surface portion can be adjusted easily with the total amount of the light-permeable resin supplied per unit time being secured.

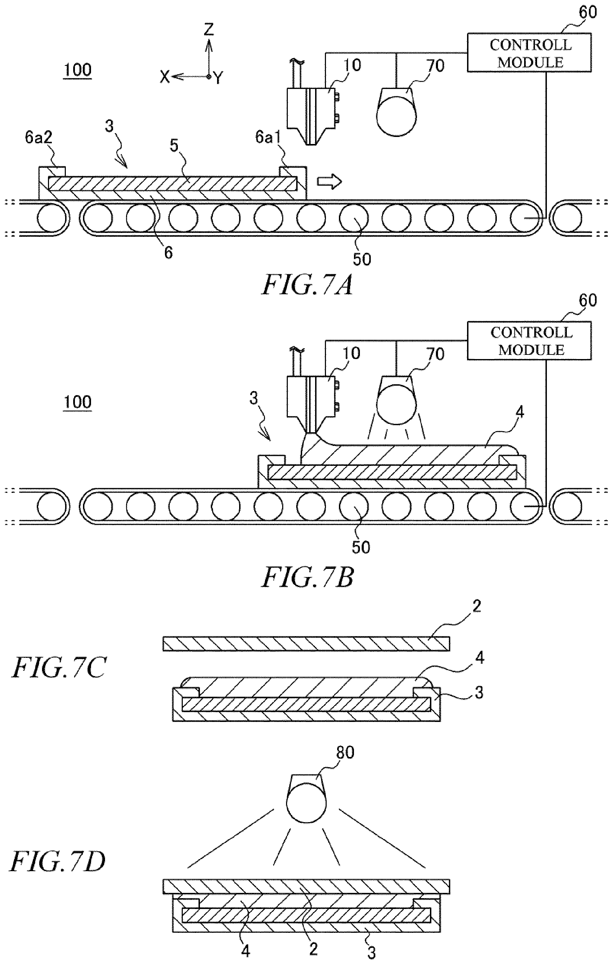

As shown in FIG. 7, for example, supplying the light-permeable resin may be continued while the die head is moved from a position above the frame adjacent to a first edge of the image display panel to a position above the frame adjacent to a second edge facing the first edge.

With the configuration as described above, the light-permeable resin can be applied onto the entire frame formed along the outer periphery of the image display panel 3 by performing the supplying the light-permeable resin onto the image display panel only once.

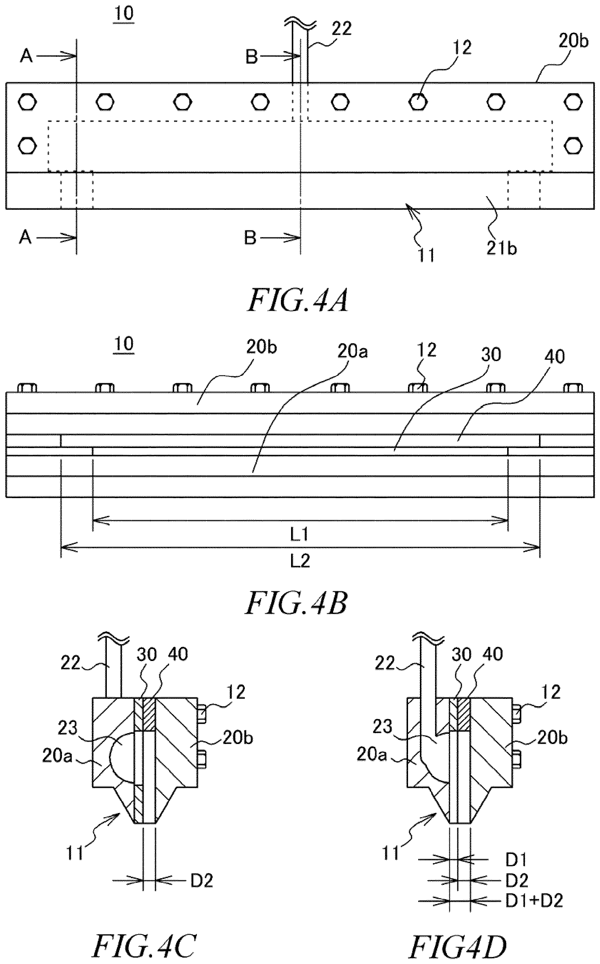

As shown in FIG. 4, for example, the first selected shim may have a wall thickness that is smaller than that of the second selected shim.

With the configuration as described above, the light-permeable resin can be stably applied onto the frame.

### EFFECT OF THE INVENTION

According to the present invention, it is possible to achieve a good joining result even when a light-permeable member is joined to an image display panel having ajoint surface with unevenness formed thereon.

### BRIEF DESCRIPTION OF DRAWINGS

FIG. 1 is a schematic cross-sectional view, illustrating a joined member according to one embodiment based on dimensions of the image display panel 3, the amount of the light-permeable resin applied onto the frame and the amount of the light-permeable resin applied onto the main surface portion can be adjusted easily with the total amount of the light-permeable resin supplied per unit time being secured.

As for the method for manufacturing a joined member according to the fourth aspect of the present invention, as shown in FIG. 7, for example, in the method for manufacturing a joined member according to the third aspect, wherein the supplying the light-permeable resin is continued while the die head is moved from a position above the frame adjacent to a first edge of the image display panel to a position above the frame adjacent to a second edge facing the first edge.

With the configuration as described above, the light-permeable resin can be applied onto the entire frame formed along the outer periphery of the image display panel 3 by performing the supplying the light-permeable resin onto the image display panel only once.

As for the method for manufacturing a joined member according to the fifth aspect of the present invention, as shown in FIG. 4, for example, in the method for manufacturing a joined member according to the third aspect or the fourth aspect, wherein the first selected shim has a wall thickness that is smaller than that of the second selected shim.

With the configuration as described above, the light-permeable resin can be stably applied onto the frame.

### EFFECT OF THE INVENTION

According to the present invention, it is possible to achieve a good joining result even when a light-permeable member is joined to an image display panel having a joint surface with unevenness formed thereon.

### BRIEF DESCRIPTION OF DRAWINGS

FIG. 1 is a schematic cross-sectional view, illustrating a joined member according to one embodiment of the present invention.
FIG. 2 is a perspective view, illustrating an image display panel according to one embodiment of the present invention.
FIG. 3 is an exploded perspective view of a die head according to one embodiment of the present invention.
FIG. 4 illustrates a die head according to one embodiment of the present invention, where FIG. 4A is a front view, FIG. 4B is a bottom view, FIG. 4C is a cross-sectional view, taken along A-A of FIG. 4A, and FIG. 4D is a cross-sectional view, taken along B-B of FIG. 4A.
FIG. 5 illustrates first and second shims according to one embodiment of the present invention, where FIG. 5A is a front view of the first shim and FIG. 5B is a front view of the second shim.
FIG. 6 is a flowchart, showing a method for manufacturing a joined member according to one embodiment of the present invention.
FIG. 7 is a schematic explanatory view, illustrating an application process and a joining process in the method for manufacturing a joined member according to one embodiment of the present invention.
FIG. 8 is a schematic explanatory view, illustrating part of an apparatus for manufacturing a joined member according to a modification of one embodiment of the present invention and an application process in a method for manufacturing a joined member using the apparatus.

### DETAILED DESCRIPTION OF THE INVENTION

Each embodiment for implementing the present invention is described hereinafter with reference to the drawings. It should be noted that, in the following, the range necessary for an explanation to accomplish the purpose of the present invention is shown schematically, the range necessary for an explanation of the corresponding part of the present invention is primarily described, and the parts for which description is omitted are in accordance with well-known technologies.

Before describing a manufacturing method according to the present invention, a configuration of a joined member that is produced by the present invention is firstly described. FIG. 1 is a schematic cross-sectional view illustrating an image display device as a joined member according to one embodiment of the present invention. As shown in FIG. 1, an image display device (joined member) 1 that is produced by the present invention includes a light-permeable cover member 2, an image display panel 3, and a light-permeable resin 4 for joining them.

The light-permeable cover member 2 is located on a display surface side of the image display panel 3 and provided, for example, to protect the image display panel 3, and is composed of a plate-like or sheet-like member having light permeability so that an image displayed on the image display panel 3 can be visually recognized. As a specific material of this light-permeable cover member 2, glass, acrylic resin, polycarbonate or the like can be employed, and its shape can be, for example, a rectangle that is substantially the same as or larger than the image display panel 3. Also, an outer peripheral area (frame area FA) of the light-permeable cover member 2 may be colored in black or the like to improve image contrast.

FIG. 2 is a perspective view illustrating the image display panel according to one embodiment of the present invention. As shown in FIG. 1 and FIG. 2, the image display panel 3 includes an image display panel main body 5, and a housing 6 for covering the image display panel main body 5. Also, although not shown, various components associated with the image display panel main body 5, such as a back light unit including a light guide plate, LED light source or the like, a circuit board for various controls, and so on may be disposed in the housing 6 in addition to the image display panel main body 5.

The image display panel main body 5 is constituted of a panel of various types having a rectangular shape with a size of 7.62 centimeters to 127 centimeters (3 inches to 50 inches), such as a liquid crystal display panel, organic EL panel, plasma display panel or the like, and can display a desired image on its main surface portion 5a. Also, the main surface portion 5a of the image display panel main body 5 may include a touch panel or the like having a laminate structure.

The housing 6 is a member for accommodating therein at least the image display panel main body 5, and is formed by, for example, bending a thin metal plate. This housing 6 is formed to at least partially cover a back surface and four side surfaces with respect to the display surface of the image display panel 5, and includes a frame 6a for covering an outer periphery of the display surface of the image display panel 5. The frame 6a may be formed along the entire circumference of the outer periphery of the display surface of the image display panel 5 as illustrated in FIG. 2, or may be formed to cover the outer periphery only partially. In the following, the area of the outer periphery of the image display panel main body 5 covered with the frame 6a is referred to as "frame area FA," and the area that is surrounded by the frame area FA and forms the main surface portion 5a of the image display panel 3 on which an image is displayed is referred to as "display area DA."

As described above, in this embodiment, the frame 6a as part of the housing 6 of the image display panel 3 is illustrated as a member that defines the frame area FA. However, the member that defines the frame area FA is not limited to the above-mentioned frame 6a, and various members can be allowed as long as they are structures that are arranged along the outer periphery of the image display panel. Similarly, the specific configuration of the image display panel 3 in this embodiment is not limited to the above-mentioned configuration, and various configurations, such as a configuration without the housing, a configuration in which the panel is not entirely flat but partially or entirely curved, a configuration in which the panel has a shape other than a rectangular shape or the like, can be employed.

The light-permeable resin 4 is an adhesive for joining the light-permeable cover member 2 and the image display panel 3, and, as described later, is applied to the entire surface of the image display panel 3 across both the display area DA and the frame area FA of the image display panel 3. As the light-permeable resin 4, it is preferred to employ a resin that has light permeability and has a predetermined viscosity (specifically, a viscosity in the range of 1.0 to 20.0 Pa·s) before being cured. Specifically, as the light-permeable resin 4, an ultraviolet (UV) curable type resin, an ultraviolet-heat curing combination type resin or the like can be used.

Here, as shown in FIG. 1 and FIG. 2, level difference portions 7 resulting from a wall thickness of the frame 6a are formed in a boundary area between the frame 6a and the main surface portion 5a, that is, at the boundary between the frame area FA and the display area DA, of the image display panel 3, which constitutes part of the joined member in the present invention. The level difference portions 7 have a dimension h that is as considerably large as 0.3 to 3 mm. Such a large dimension h of the level difference portions 7 is due to the fact that the frame 6a, from which the level difference portions 7 result, is composed of a structure such as a metal plate, and the wall thickness of the frame 6a tends to increase in proportion to the size of the image display panel 3 or the strength required therefor. Thus, if the light-permeable resin is applied only to the light-permeable cover member side in case that the light-permeable cover member 2 is joined to the image display panel 3 including the level difference portions 7 in this embodiment, the parts of the level difference portions 7 are not completely wetted with the light-permeable resin because of the large dimension h of the level difference portions 7 when the image display panel 3 and the light-permeable cover member 2 are bonded to each other (even if the applied light-permeable resin is applied flatly). As a result, air remains to form bubbles in the non-wetted portion, causing a problem of decreased yield.

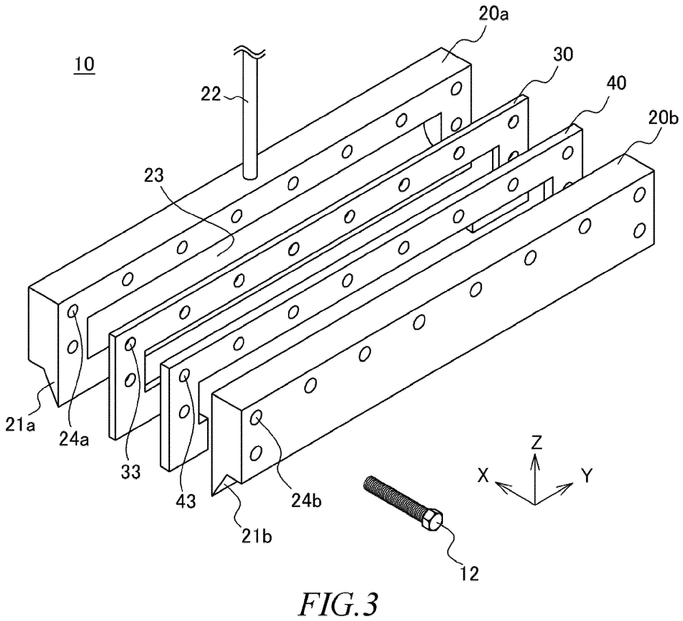

The inventors investigated various methods to solve the above problem, and, consequently, found that this problem can be solved by applying a light-permeable resin to the image display panel side and using an apparatus and a method optimum for applying the light-permeable resin to the image display panel side. Therefore, in the following, referring to FIG. 3 to FIG. 7, an apparatus and a method for manufacturing a joined member according to this embodiment that can solve the above-identified problem is described primarily.

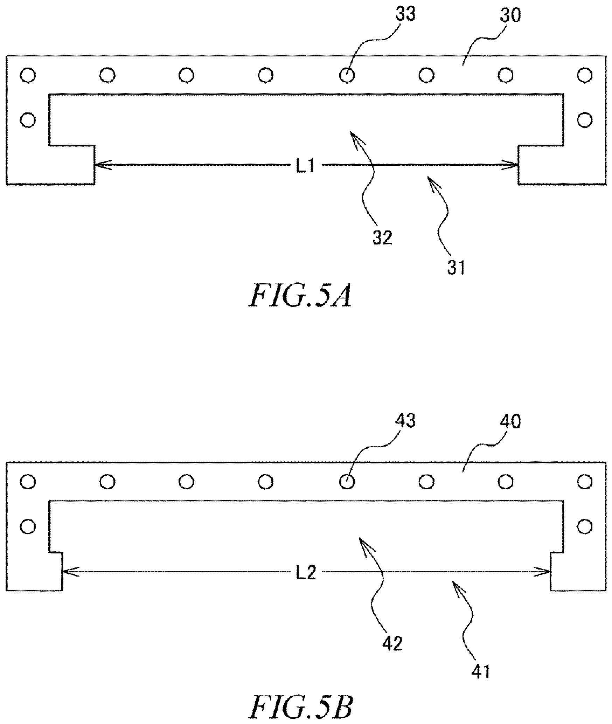

FIG. 3 is an exploded perspective view of a die head according to one embodiment of the present invention. Also, FIG. 4 illustrates the die head according to one embodiment of the present invention, FIG. 4A is a front view, FIG. 4B is a bottom view, FIG. 4C is a cross-sectional view taken along A-A of FIG. 4A, and FIG. 4D is a cross-sectional view taken along B-B of FIG. 4A. In addition, FIG. 5 illustrates first and second shims according to one embodiment of the present invention, FIG. 5A is a front view of the first shim, and FIG. 5B is a front view of the second shim. It should be noted that, in the drawings described below, a direction in which a die head 10 and the image display panel 3 are moved relative to each other is defined as X-direction, a direction extending perpendicular to the X-direction and horizontally is defined as Y-direction, and an up-down direction or vertical direction of the die head 10 is defined as Z-direction (as shown in FIG. 3 and so on).

A joined member manufacturing apparatus 100 (see FIG. 7) of the application includes the die head 10 that is shown in FIG. 3 and FIG. 4. The die head 10 constitutes part of an application device for applying the light-permeable resin 4 to the image display panel 3. Also, the die head 10 includes: a pair of die blocks 20a, 20b having generally the same outer shape and arranged with their joint surfaces facing each other; and a first shim 30 and a second shim 40 detachably interposed between the joint surfaces of the paired die blocks 20a, 20b to define a dispensing port of the die head 10.

The paired die blocks 20a, 20b are constituted of block bodies each having a generally rectangular parallelepiped shape elongated in the Y-direction, and have protruded portions 21a, 21b, respectively, formed on their bottom surface portions on the side of the joint surfaces facing each other and extending at an acute angle to constitute a nozzle (dispensing port) 11 of the die head 10. Also, a supply path 22 for supplying the light-permeable resin 4 to the die head 10 is connected to one of the paired die blocks 20a, 20b, for example, the die block 20a, at a center of an upper surface thereof. A pumping machine (for example, pump unit) (not shown) is provided at an upstream end of the supply path 22, and the light-permeable resin 4 is supplied into the die head 10 by operating the pumping machine. Although an example in which the supply path 22 is connected to one die block 20a only at one location at the center of the upper surface thereof is shown in this embodiment, its connecting position and the number of supply paths 22 can be changed as appropriate in view of the size of the die head 10, the amount of the light-permeable resin 4 to be supplied, and so on.

Also, a manifold 23 constituted of a semi-cylindrical space extending in the Y-direction is formed at a central position of a facing surface of the die block 20a, to which the supply path 22 is connected, and the manifold 23 is communicated with the supply path 22. As a result, because the light-permeable resin 4 supplied from the supply path 22 is dispensed from the nozzle 11 after being filled in the manifold 23, stable dispensing of the light-permeable resin 4 over the entire length of the nozzle 11 can be achieved.

As shown in FIG. 5, the first shim 30 and the second shim 40 are each made of a metal plate having a predetermined uniform wall thickness, and their external dimensions are substantially the same as those of the shape of the facing surfaces of the paired die blocks 20a, 20b and their outer shape is a generally C-shape extending in the Y-direction and opening downward. The first shim 30 and the second shim 40 have a first dispensing port 31 and a second dispensing port 41, respectively, formed at their lower part for ejecting the light-permeable resin 4. The first dispensing port 31 and the second dispensing port 41 have Y-direction lengths L1 and L2, respectively, that satisfy the relationship "L1 < L2." This is because the first dispensing port 31 is selected so as to correspond to the length of the display area DA of the image display panel 3 whereas the second dispensing port 41 is selected so as to correspond to the lengths of the display area DA and the frame area FA of the image display panel 3.

Also, a first communication portion 32 and a second communication portion 42 which are communicated with the manifold 23 of the die block 20a and into which the light-permeable resin 4 supplied via the manifold 23 flows are formed above the dispensing ports 31 and 41, respectively. The first communication portion 32 and the second communication portion 42 have external dimensions (that is, dimensions in the Y-direction and Z-direction) that are adjusted in conformity with, for example, an opening shape of the manifold 23. Here, as shown in FIG. 5, the first communication portion 32 or the second communication portion 42 preferably has a Y-direction length that is longer than the Y-direction length L1 or L2 of the first dispensing port 31 or the second dispensing port 41. Then, the fluidity of the light-permeable resin 4 passing through, in particular, Y-direction ends of the first dispensing port 31 or the second dispensing port 41 can be increased and more stable application of the light-permeable resin 4 can be achieved. It should be noted that the first and second shims 30, 40 according to the present invention are not limited to the above-mentioned shapes, and may have generally U-shaped outer shapes with the Y-direction lengths of the first communication portion 32 and the second communication portion 42 equal to the Y-direction lengths L1 and L2 of the first dispensing port 31 and the second dispensing port 41, respectively, for example.

Here, as apparent particularly from the description of FIG. 4C and FIG. 4D, it should be particularly noted that the first shim 30 is formed to have a wall thickness (X-direction length of the first dispensing port 31) D1 that is smaller than that of the second shim 40 (X-direction length of the second dispensing port 41) D2. A specific example is used for explanation. For example, when the light-permeable resin 4 is desired to be applied with a film thickness of 1.5 mm to the display area DA and with a film thickness of 0.5 mm to the frame area FA on the image display panel 3 having the level difference portions 7 with a dimension h = 1.0 mm, the first and second shims 30 and 40 that satisfy a wall thickness D1 = 0.3 mm and a wall thickness D2 = 0.5 mm, respectively, are selected as the shims for use in this embodiment. In other words, the X-direction length of the part of the nozzle 11 for forming a film of the light-permeable resin 4 with a film thickness of 1.5 mm is D1 + D2 = 0.8 mm, whereas the X-direction length of the part of the nozzle 11 for forming a film of the light-permeable resin 4 with a film thickness of 0.5 mm is D2 = 0.5 mm. As described above, in the present invention, it is ensured that a given amount of the light-permeable resin 4 passes through both Y-direction ends of the second dispensing port 41 by not making the wall thickness D2 of the second shim 40 too small. It should be noted that while one shim with a desired wall thickness is selected as each of the first and second shims 30, 40 in this embodiment, the present invention is not limited thereto, and the first and second shims 30, 40 may be constituted by stacking a plurality of shims with the same shape to obtain appropriate wall thicknesses as the first and second shims 30, 40, for example.

The paired die blocks 20a, 20b and the first and second shim 30, 40 that are configured as described above have bolt holes 24a, 24b, 33 and 43, respectively, formed at a plurality of (ten in this embodiment) corresponding positions. The die head 10 is assembled such that the paired die blocks 20a, 20b and the first and second shims 30, 40 interposed between the joint surfaces of the paired die blocks 20a, 20b are fastened together by tightening bolts 12 into the bolt holes 24a, 24b, 33 and 43 formed through these members. While the positions where these members are fastened by the bolts 12 and the numbers thereof may be changed as appropriate, it is preferable to fasten at a plurality of locations at relatively small intervals so as to surround the flow path for the fluid flowing in the die head 10 in order to prevent liquid leakage from gaps between the die blocks 20a, 20b and each of the shims 30, 40, for example.

The joined member manufacturing apparatus 100 of this application further includes an actuator 50 for moving the image display panel 3 relative to the die head 10, and a control module 60 for controlling the die head 10 and the actuator 50, in addition to the above-mentioned die head 10.

The actuator 50 is a mechanism for relatively moving the die head 10 above a surface of the image display panel 3, and for operating either the image display panel 3 side, the die head 10 side, or both. In this embodiment, the die head 10 is stationary, and a mechanism for moving only the image display panel 3 relative to the die head 10 is used. As a specific configuration of the actuator 50, any configuration is possible as long as the image display panel 3 can be moved horizontally in the X-direction, and a well-known conveyer as described in FIG. 7, a mounting table movable horizontally or the like can be employed, for example.

The control module 60 is connected to various members constituting the joined member manufacturing apparatus 100 via a signal cable or the like, and at least performs operational control of the actuator 50 and control of the amount of the light-permeable resin 4 supplied from the die head 10 per unit time. The control module 60 may not only perform the above-mentioned two control functions but also collectively perform control over various members constituting the joined member manufacturing apparatus 100 such as operational control of ultraviolet curing devices 70, 80 described later, and control over the process of bonding the image display panel 3 and the light-permeable cover member 2. Also, the control module 60 can control the film thickness in a direction in which the image display panel 3 is moved by adjusting the amount of the light-permeable resin 4 dispensed from the die head 10 per unit time and/or the movement speed brought by the actuator 50. A specific method for controlling them is described later. As a specific configuration of the control module 60, a computer equipped with a well-known CPU or microcomputer may be employed, for example.

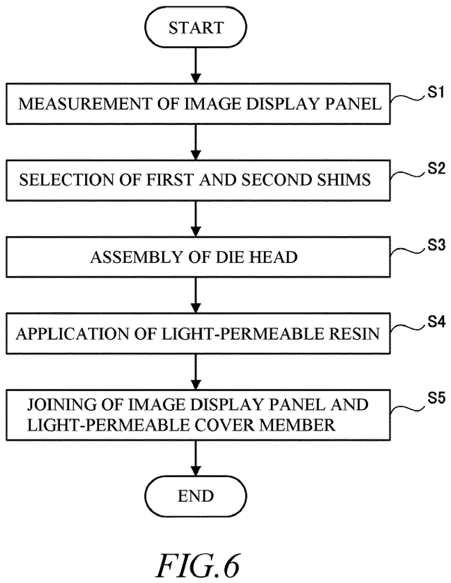

A method for manufacturing a joined member using the joined member manufacturing apparatus 100 including the above-mentioned die head 10 and so on is described below. FIG. 6 is a flowchart showing a method for manufacturing a joined member according to one embodiment of the present invention. The method for manufacturing a joined member described below also serves as a description of the effects of the above-mentioned joined member manufacturing apparatus 100. While the method for producing a joined member described below is typically performed using the above-mentioned joined member manufacturing apparatus 100, the method may be performed using any other apparatus other than the joined member manufacturing apparatus 100.

### <Shim selection process>

In the method for manufacturing a joined member according to this embodiment, first of all, the first shim 30 and the second shim 40 to be attached to the die head 10 are selected. Therefore, in the joined member manufacturing apparatus 100 in this embodiment, a plurality of types of shims different in wall thickness and different in Y-direction length of the dispensing port is prepared in advance for each die head 10. Also, this shim selection process is performed every time a dimension of the image display panel 3 as an application target is changed, and this process can be omitted for the same image display panel 3. To select shims, at least the dimensions of the image display panel 3 as an application target are necessary. Thus, in this process, dimensions of the image display panel 3 are previously measured (step S1). The dimensions include the Y-direction length of the entire image display panel 3, the Y-direction length of the main surface portion 5a, the dimension h of the level difference portions 7 and so on. The specific method for the measurement of these dimensions is not particularly limited.

Once the dimensions of the image display panel 3 are determined, this manufacturing method selects the first shim 30 and the second shim 40 (step S2) in view of the dimensions and other necessary information (such as the viscosity of the light-permeable resin 4 to be applied and the desired application thickness). By this selection, a shim having a predetermined wall thickness D1 and a predetermined length L1 of the first dispensing port 31 is selected as the first shim 30 based mainly on the viscosity of the light-permeable resin 4, the desired application thickness, the determined Y-direction length of the main surface portion 5a and the shape of the selected second shim 40 described later, and also a shim having a predetermined wall thickness D2 and a predetermined length L2 of the second dispensing port 41 is selected as the second shim 40 based mainly on the viscosity of the light-permeable resin 4, the desired application thickness, the determined dimension h of the level difference portions 7 and the Y-direction length of the entire image display panel 3. To facilitate this shim selection, it is preferable to prepare in advance a database to which reference can be made during shim selection. The database includes, as indices, at least, data for the viscosity of the light-permeable resin 4 and the dimension h of the level difference portions 7, and data for the thicknesses of the first and second shims corresponding thereto. The data may be in a table form, for example, in which the correspondence relationship among the viscosity of the light-permeable resin 4, the dimension h of the level difference portions 7, an optimum shim thickness and so on, that are determined through a plurality of tests are included. Also, in this case, it is preferable to make a selection such that the wall thickness D1 of the first shim 30 (in other words, the width of the first dispensing port 31 in the X-direction) is smaller than the wall thickness D2 of the second shim 40 (in other words, the width of the second dispensing port 41 in the X-direction) although this is optional in this manufacturing method. It should be noted that the length L1 of the first dispensing port 31 of the selected first shim 30 corresponds to the determined Y-direction length of the main surface portion 5a but they are not necessarily the same in length as long as the light-permeable resin 4 can be applied to the entire display area DA with a desired application thickness. Similarly, the length L2 of the second dispensing port 41 of the selected second shim 40 corresponds to the determined Y-direction length of the entire image display panel 3 but they are not necessarily the same in length as long as the light-permeable resin 4 can be applied to the frame area FA with a desired application thickness.

A structure for adjusting the application amount of the light-permeable resin using shims as described above provides very effective effects when the light-permeable resin 4 is applied to the image display panel 3 side. In other words, when a light-permeable resin is applied to a light-permeable cover member side (as described in Patent Document 1), for example, the light-permeable cover member is usually constituted of a single plate such as mere glass and has no attached structure (such as the housing 6 in the image display panel 3, for example). Thus, it is difficult to consider level difference portions formed on a light-permeable cover member for reasons other than a light-shielding layer. Here, because the light-shielding layer is a film generally formed by screen printing with a black paint, its film thickness is very small (5 to 100 µm, for example) and is not something varying significantly even when the light-permeable cover member is changed. In other words, in an apparatus for applying a light-permeable resin to the light-permeable cover member side, an aspect is not considered from the beginning in which the amount of the light-permeable resin applied is significantly changed depending on the change of the application target because the size of level difference portions formed on the light-permeable cover member hardly varies even when its implementation aspect is different. However, as described above, when the light-permeable resin 4 is applied to the image display panel 3 side as in this application, a unique problem is included, i.e., it is necessary to change the application amount significantly depending on the image display panel 3 as an application target, because the resin supply amount necessary for the application is relatively large (because the level difference portions 7 formed on the image display panel 3 are larger than the level difference portions that may be formed on the light-permeable cover member 2), and because the height of the level difference portions formed significantly varies (up to approximately ten-fold, for example) depending on the size, shape and so on of the image display panel 3. Therefore, the present invention provides, as specific means for solving the unique problem, a manufacturing method and a manufacturing apparatus corresponding thereto that employs the die head 10 using shims so as to be applicable to image display panels 3 of various sizes and shapes with a necessary supply amount secured by simply changing the first and second shims 30, 40.

### <Die head assembly process>

Once the first and second shims 30 and 40 are selected by step S2, this manufacturing method proceeds to a next process to assemble the die head 10. The assembly process is performed by aligning a pair of die blocks 20a, 20b preliminarily determined and the first and second shims 30, 40 selected in step S2, in the order of the die block 20a, the first shim 30, the second shim 40, and the die block 20b from the upstream side in the direction of the (relative) movement of the image display panel 3, and securely fastening them together into a unitary body with a plurality of bolts 12. It should be noted that the alignment positions of the first shim 30 and the second shim 40 are not limited to the above, and the second shim 40 may be located upstream side of the first shim 30.

### <Application process>

After preparing the manufacturing apparatus by the above-mentioned process, this manufacturing method proceeds to performing application of the light-permeable resin 4 to the image display panel 3 (step S4). FIG. 7 is a schematic explanatory view illustrating an application process and a joining process in the method for producing a joined member according to one embodiment of the present invention. It should be noted that only the image display device 1 is shown in a cross-sectional view in FIG. 7 so that the processes can be easily understood. In performing these processes, the joined member manufacturing apparatus 100 is firstly prepared. The manufacturing apparatus 100 includes at least the actuator 50 constituted of a conveyer that can transport a target in the X-direction, the die head 10 disposed at a position downstream of the transportation route of the actuator 50 and at a predetermined distance above the actuator 50 and fixed with its longitudinal direction extending along the Y-direction perpendicular to the X-direction, and the control module 60 for controlling the actuator 50 and the die head 10 as shown in FIG. 7A. Then, the image display panel 3 as an application target is mounted on the actuator 50, and the actuator 50 is driven using the control module 60 to transport the image display panel 3 to the die head 10 side. It should be noted that the position of the image display panel 3 in the Y-direction during transportation by the actuator 50 is determined such that the Y-direction length of the main surface portion 5a corresponds to the length L1 of the first dispensing port 31 of the fixed die head 10. Also, the height of the die head 10 with respect to the actuator 50 is adjusted to a height that allows passage of the image display panel 3 transported by the actuator 50 and, more preferably, the height can be changed so that the light-permeable resin 4 that is applied at the height cannot be placed disproportionately on the image display panel 3.

Then, the supply of the light-permeable resin 4 from the die head 10 is started by the control module 60 at a time when a frame adjacent to an edge (first edge) of the image display panel 3 on the upstream side (this part of the frame is referred to as "frame 6a1" for simplicity) with respect to the direction in which the image display panel 3 is transported (X-direction) by the actuator 50 (at a speed of 5 to 30 mm/sec, for example) passes under the nozzle 11 of the die head 10. The supply of the light-permeable resin 4 is continued until a frame adjacent to an edge (second edge) of the image display panel 3 on the downstream side (this part of the frame is referred to as "frame 6a2" for simplicity as in the case with above) with respect to the direction in which the image display panel 3 is transported (X-direction) passes under the nozzle 11 of the die head 10. It should be noted that the light-permeable resin 4 to be applied to the frames 6a1, 6a2 does not have to be applied so as to cover the entire surface areas of the frames 6a1, 6a2 at the time of this application process. This is because the light-permeable resin 4 is pressed by the light-permeable cover member 2 and spread in the X and Y-directions, and, consequently, covers the entire areas of the frames 6a1, 6a2 in a bonding step included in the subsequent joining process.

In this sequential application process, as described above, the light-permeable resin 4 is also applied onto the frame 6a1 and the frame 6a2. Here, because upper parts of the frame 6a1 and the frame 6a2 are included in the frame area FA, the amount of the light-permeable resin 4 to be applied to these parts must be smaller than the amount of the light-permeable resin 4 to be applied to the display area DA in order to form a flat applied surface over the entire surface of the image display panel 3. Thus, in the present invention, in order to control the amount of the light-permeable resin 4 to be applied to the upper parts of the frame 6a1 and the frame 6a2, the speed at which the image display panel 3 is moved by the actuator 50 can be changed by the control module 60. Specifically, the speed at which the image display panel 3 is moved by the actuator 50 is increased only during the period while the upper part of the frame 6a1 and the upper part of the frame 6a2 pass under the nozzle 11. It should be noted that the method for controlling the application amount onto the upper part of the frame 6a1 and the upper part of the frame 6a2 is not limited to the above-mentioned method in the present invention, and it is possible to control the application amount onto the upper part of the frame 6a1 and the upper part of the frame 6a2 by, for example, a method in which the amount of the light-permeable resin 4 supplied from the die head 10 can be changed.

### <Joining process>

Once the light-permeable resin 4 is applied to the image display panel 3 in step S4, this manufacturing method proceeds to a next process to join the image display panel 3 and the light-permeable cover member 2. Various joining processes are already known in the technical field of a method for producing a joined member, and the details of the joining process are not particularly limited in the present invention. In this embodiment, the process includes for example, a preliminary curing step, a bonding step and a final curing step.

As shown in FIG. 7A and FIG. 7B, once the light-permeable resin 4 is applied to the image display panel 3, in this embodiment, the preliminary curing step is firstly performed to decrease the fluidity of the light-permeable resin 4 applied. In this regard, an ultraviolet curable type resin is employed as the light-permeable resin 4 in this embodiment, and the joined member manufacturing apparatus 100 according to this embodiment further includes a preliminary curing ultraviolet irradiation device 70 disposed adjacent to the die head 10 and downstream of the die head 10 with respect to the direction in which the image display panel 3 is transported and.

The preliminary curing ultraviolet irradiation device 70 emits an optimum amount of UV light for an optimum period of time to decrease the fluidity of the light-permeable resin 4 with its adhesivity (tacking properties) necessary for joining with the light-permeable cover member 2 maintained by irradiating the light-permeable resin 4 composed of an ultraviolet curable type resin with UV light. Thus, the preliminary curing ultraviolet irradiation device 70 has a configuration extending in the Y-direction so that the entire light-permeable resin 4 immediately after application of the resin to the image display panel 3 by the die head 10 can be irradiated with UV light, and is disposed in parallel with the die head 10 to irradiate the light-permeable resin 4 immediately after application by the die head 10 with UV light. By employing this preliminary curing step, it is possible to prevent the applied light-permeable resin 4 from flowing in each of the subsequent steps to cause a situation in which irregularities are formed on the surface of the resin film or the light-permeable resin 4 falls off, thereby not to obtain a desired film thickness. This step is particularly effective when the image display panel 3 itself is not flat but curved or when the light-permeable resin 4 has a low viscosity, for example.

As shown in FIG. 7C, when the above-mentioned preliminary curing step is completed, the bonding step of bonding the light-permeable cover member 2 to the image display panel 3 including the preliminarily cured light-permeable resin 4 thereon is performed. This bonding is achieved by accommodating the image display panel 3 and the light-permeable cover member 2 in a well-known vacuum chamber, retaining each of them on a corresponding suction stage, creating a generally vacuum state in the vacuum chamber, positioning the light-permeable cover member 2 at a position facing the surface of the image display panel 3 with the light-permeable resin 4 applied thereto, and bonding them by moving at least one of the stages in a direction toward the other stage, for example. In addition, with the image display panel 3 and the light-permeable cover member 2 bonded to each other, they are pressed in directions toward each other. By this pressing, the light-permeable resin 4 is spread to wet the entire surface of the light-permeable cover member 2, and the light-permeable resin 4 with a predetermined thickness is obtained.

As shown in FIG. 7D, when the above-mentioned bonding step is completed, the image display panel 3 and the light-permeable cover member 2 joined to each other are taken out of the vacuum chamber and then a final curing step of curing the light-permeable resin 4 joining the image display panel 3 and the light-permeable cover member 2 is performed to obtain a joined member. This final curing step is performed by causing a final curing ultraviolet irradiation device 80 to emit UV light toward the entire light-permeable resin 4 from the light-permeable cover member 2 side. Because a well-known device can be used as the final curing ultraviolet irradiation device 80, specific description of its structure and so on is omitted here.

As described above, according to the method for manufacturing a joined member according to one embodiment of the present invention, it is possible to obtain a flat surface of the applied resin film without generating bubbles at the parts of the level difference portions 7 formed on the image display panel 3 side with a relatively simple method by applying the light-permeable resin 4 to the image display panel 3 side. In addition, because the process of selecting the first and second shims 30, 40 is included, a surface of the applied resin film in conformity with the image display panels 3 having a different shape of unevenness and the like from product to product can be achieved easily.

### <Modification>

While a mechanism in which the image display panel 3 side is moved is described as the actuator 50 in one embodiment described above, the present invention is not limited thereto. In particular, when the application target is a large-sized (127 centimeter (50-inch), for example) image display panel 3A, for example, it is not preferred to move the large-sized image display panel 3A side from the standpoint of the space occupied by the apparatus. Thus, in the following, as a modification of one embodiment described above, a joined member manufacturing apparatus 100A employing a configuration in which the die head 10 side is movable is briefly described. It should be noted that only the structure relating to an application device of the joined member manufacturing apparatus 100A and an application process relating to the structure are described in the following, and configurations and processes described in one embodiment described above are employed for other various configurations and processes for which description is omitted.

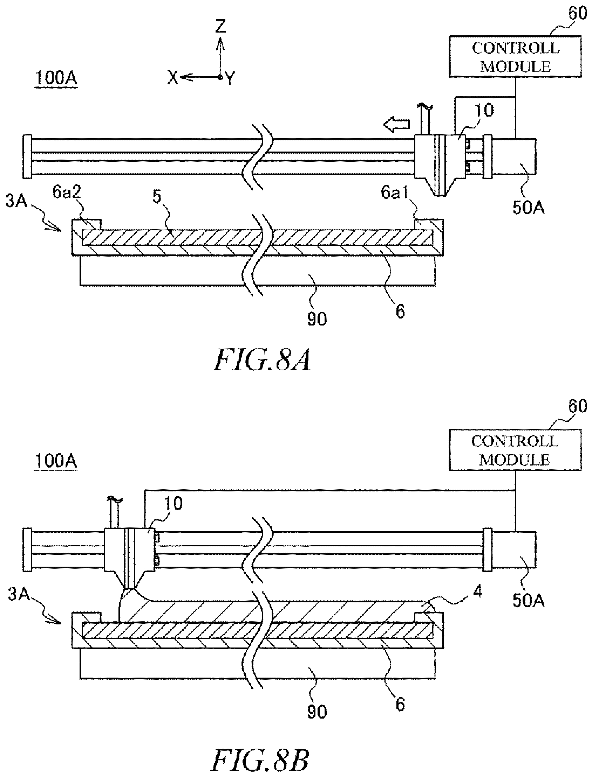

FIG. 8 is a schematic explanatory view illustrating part of a joined member manufacturing apparatus according to a modification of one embodiment of the present invention and an application process in a method for manufacturing a joined member using the apparatus. As shown in FIG. 8A and FIG. 8B, the joined member manufacturing apparatus 100A according to this modification includes a stage 90 on which the large-sized image display panel 3A is mounted. The stage 90 can preferably fix the large-sized image display panel 3A with suction means (not shown) so that the large-sized image display panel 3A mounted thereon can be positioned. Also, the joined member manufacturing apparatus 100A further includes an actuator 50A for moving the die head 10 in a direction along a display surface of the large-sized image display panel 3Amounted on the stage 90 (X-direction). As the actuator 50A, a well-known electric actuator (single-axis robot, for example) or the like may be employed.

When an applying process of applying the light-permeable resin 4 to the large-sized image display panel 3A is performed using the joined member manufacturing apparatus 100A, the large-sized image display panel 3A is firstly mounted and fixed on the stage 90. Then, the nozzle 11 of the die head 10 is positioned at a predetermined distance above the frame 6a1 using the control module 60 (see FIG. 8A), and the actuator 50A is driven to move the die head 10 in the X-direction. At the same time, the supply of the light-permeable resin 4 is started (see FIG. 8B). The supply of the light-permeable resin 4 is continued until the frame 6a2 passes under the nozzle 11 of the die head 10. It should be noted that the amount of the light-permeable resin 4 applied onto the frames 6a1 and 6a2 constituting the frame area FA is adjusted by, for example, adjusting the speed at which the die head 10 is moved by the actuator 50A (in the same manner as in the one embodiment. Also, although illustration is omitted in FIG. 8, when a preliminary curing step as described above is performed in a joining process that is performed after the applying process, it is preferred that the preliminary curing ultraviolet irradiation device 70 is fixed in parallel with the die head 10 downstream of the direction in which the die head 10 is moved so that the preliminary curing ultraviolet irradiation device 70 can be moved following the die head 10.

### DESCRIPTION OF REFERENCE NUMERALS AND SYMBOLS

- 1: image display device (joined member)
- 2: light-permeable cover member (light-permeable member)
- 3, 3A: image display panel
- 4: light-permeable resin
- 5a: main surface portion
- 6a: frame
- 7: level difference portion
- 10: die head
- 11: nozzle (dispensing port)
- 20a, 20b: die block
- 22: supply path
- 30: first shim
- 31: first dispensing port
- 40: second shim
- 41: second dispensing port
- 50, 50A: actuator
- 60: control module
- 100, 100A: joined member manufacturing apparatus
- DA: display area
- FA: frame area

## Claims

1. A method for manufacturing a joined member,
including applying a light-permeable resin (4) to a surface of an image display panel (3) using a die head (10), the image display panel (3) having a frame (6a) along an outer periphery thereof and therefore having level difference portions (7) at a boundary between the frame (6a) and a main surface portion (5a) thereof, the method comprising:
providing a pair of die blocks (20a, 20b) at least one of which has a supply path (22) for the light-permeable resin (4) formed therein and which detachably interposes a first and second shims (30, 40) to define a dispensing port (11);
selecting (S2) the first shim (30) and the second shim (40) based on an outer shape of the image display panel (3) and a dimension of the level difference portions (7), the first shim (30) constituted of a thin plate-like member having a slit-like first dispensing port (31) that defines part of the dispensing port (11) and corresponds to a length of the main surface portion (5a) in a direction in which the die head (10) extends, the second shim (40) constituted of a thin plate-like member having a slit-like second dispensing port (41) that defines part of the dispensing port (11) and has a length greater than the length of the main surface portion (5a) in the direction in which the die head (10) extends;
assembling (S3) the die head (10) by interposing the first and second selected shims (30, 40) between the pair of die blocks (20a, 20b);
supplying (S4) the light-permeable resin (4) from the dispensing port (11) while relatively moving the die head (10) above a surface of the image display panel (3); and
joining (S5) a light-permeable member (2) to the surface of the image display panel (3) with the light-permeable resin (4) supplied thereon.

2. The method for manufacturing a joined member of claim 1,
wherein the supplying (S4) the light-permeable resin (4) is continued while the die head (10) is moved from a position (6a1) above the frame (6a) adjacent to a first edge of the image display panel (3) to a position (6a2) above the frame (6a) adjacent to a second edge facing the first edge.

3. The method for manufacturing a joined member of claim 1 or claim 2,
wherein the first selected shim (30) has a wall thickness that is smaller than that of the second selected shim (40).

## Patentansprüche

1. Verfahren zur Herstellung eines verbundenen Elements,
einschließlich eines Auftragens eines lichtdurchlässigen Harzes (4) auf eine Oberfläche einer Bildanzeigetafel (3) mittels eines Formkopfes (10) auf eine Oberfläche einer Bildanzeigetafel (3), wobei die Bildanzeigetafel (3) einen Rahmen (6a) entlang ihres äußeren Umfangs aufweist und daher Höhenunterschiedsabschnitte (7) an einer Grenze zwischen dem Rahmen (6a) und einem Hauptoberflächenabschnitt (5a) aufweist, wobei das Verfahren umfasst:
ein Bereitstellen eines Paares an Matrizenblöcken (20a, 20b), von denen mindestens einer einen Zuführungspfad (22) für das darin ausgebildete lichtdurchlässige Harz (4) aufweist und in den ein erstes und ein zweites Abstandsstück (30, 40) lösbar eingesetzt sind, um eine Ausgabeöffnung (11) zu bestimmen;
ein Auswählen (S2) des ersten Abstandsstücks (30) und des zweiten Abstandsstücks (40) auf der Grundlage einer äußeren Form der Bildanzeigetafel (3) und einer Abmessung der Höhenunterschiedsabschnitte (7), wobei das erste Abstandsstück (30) aus einem dünnen plattenartigen Element, das eine schlitzartige ersten Ausgabeöffnung (31) aufweist, gebildet ist, die einen Teil der Ausgabeöffnung (11) bestimmt und die einer Länge des Hauptoberflächenabschnitts (5a) in einer Richtung entspricht, in der sich der Formkopf (10) erstreckt, das zweite Abstandsstück (40), das aus einem dünnen plattenartigen Element, das eine schlitzartige zweiten Ausgabeöffnung (41) aufweist, gebildet ist, die einen Teil der Ausgabeöffnung (11) bestimmt und die eine Länge aufweist, die größer als die Länge des Hauptoberflächenabschnitts (5a) in der Richtung ist, in der sich der Formkopf (10) erstreckt;
ein Zusammenbauen (S3) des Formkopfes (10) durch ein Einsetzen des ersten und des zweiten ausgewählten Abstandsstücks (30, 40) zwischen dem Paar der Formköpfe (20a, 20b);
ein Zuführen (S4) des lichtdurchlässigen Harzes (4) aus der Ausgabeöffnung (11) während der Formkopf (10) relativ über eine Oberfläche der Bildanzeigetafel (3) bewegt wird; und
ein Verbinden (S5) eines lichtdurchlässigen Elements (2) an die Oberfläche der Bildanzeigetafel (3) mit dem darauf zugeführten lichtdurchlässigen Harz (4).

2. Verfahren zur Herstellung eines verbundenen Elements nach Anspruch 1,
wobei das Zuführen (S4) des lichtdurchlässigen Harzes (4) fortgesetzt wird, während der Formkopf (10) von einer Position (6a1) oberhalb des Rahmens (6a) angrenzend an eine erste Kante der Bildanzeigetafel (3) zu einer Position (6a2) oberhalb des Rahmens (6a) angrenzend an eine zweite Kante gegenüber der ersten Kante bewegt wird.

3. Verfahren zur Herstellung eines verbundenen Elements nach Anspruch 1 oder Anspruch 2,
wobei das erste ausgewählte Abstandsstück (30) eine geringere Wandstärke als das zweite ausgewählte Abstandsstück (40) aufweist.

## Revendications

1. Procédé de fabrication d'un élément assemblé,
incluant l'application d'une résine perméable à la lumière (4) sur la surface d'un panneau d'affichage d'image (3) en utilisant une tête de filière (10), le panneau d'affichage d'image (3) ayant un cadre (6a) le long d'une périphérie extérieure dudit et ayant de ce fait des portions à différence de niveau (7) à une limite entre le cadre (6a) et une portion de surface principale (5a), la méthode comprenant les étapes consistant à :
proposer une paire de blocs de filière (20a, 20b) dont au moins un a un chemin d'alimentation (22) pour la résine perméable à la lumière (4) qui y est formé et qui interpose de façon détachable une première et une seconde cales (30, 40) pour définir un port de distribution (11) ;
sélectionner (S2) la première cale (30) et la seconde cale (40) sur la base d'une forme extérieure du panneau d'affichage d'image (3) et une dimension des portions de différence de niveau (7), la première cale (30) étant constituée d'une membrure de type plaque mince ayant un premier port de distribution (31) en forme de fente qui définit une partie du port de distribution (11) et correspond à une longueur de la portion de surface principale (5a) dans une direction dans laquelle la tête de filière (10) s'étend, la seconde cale (40) étant constituée d'une membrure de type plaque mince ayant un second port de distribution (41) en forme de fente qui définit une partie du port de distribution (11) et a une longueur supérieure à la longueur de la portion de surface principale (5a) dans la direction dans laquelle la tête de filière (10) s'étend ;
assembler (S3) la tête de filière (10) en interposant la première et la seconde cales choisies (30, 40) entre la paire de blocs de filière (20a, 20b) ;
alimenter (S4) la résine perméable à la lumière (4) depuis le port de distribution (11) tout en déplaçant de façon relative la tête de filière (10) au-dessus d'une surface du panneau d'affichage (3) d'image ; et
assembler (S5) une membrure perméable à la lumière (2) à la surface du panneau d'affichage (3) d'image sur laquelle est placée la résine perméable à la lumière (4).

2. Procédé de fabrication d'un élément assemblé selon la revendication 1,
dans lequel la distribution (S4) de la résine perméable à la lumière (4) se poursuit pendant que la tête de filière (10) est déplacée depuis une position (6a1) au-dessus du cadre (6a) adjacent à un premier bord du panneau d'affichage (3) d'image vers une position (6a2) au-dessus du cadre (6a) adjacent à un second bord faisant face au premier bord.

3. Procédé de fabrication d'un élément assemblé selon la revendication 1 ou la revendication 2,
dans lequel la première cale sélectionnée (30) a une épaisseur de paroi qui est plus petite que celle de la seconde cale (40).
